# EUROPÄISCHE PATENTANMELDUNG

(11) **EP 0 955 702 A1**
(43) Veröffentlichungstag der Anmeldung: **10.11.1999**
(21) Anmeldenummer: 99107699.3
(22) Anmeldetag: 17.04.1999
(51) Int. Cl.: H01R 17/12, H01R 9/05

(54) **Verbindungsvorrichtung für gedruckte Leiterplatte**

(30) Priorität: 05.05.1998 DE 29808048 U
(71) Anmelder: Festo AG & Co, 73734 Esslingen (DE)
(72) Erfinder: Franz, Jochen, 72762 Reutlingen (DE); Rühle, Peter, 71384 Weinstadt-Schnait (DE); Böck, Jürgen, 73760 Ostfildern (DE)
(74) Vertreter: Abel, Martin, Dipl.-Ing.

(57) **Zusammenfassung**

Es wird eine Verbindungsvorrichtung zur elektrischen Verbindung einer Trägerplatte (18) mit einem anderen Bauteil (4) vorgeschlagen. Die Trägerplatte (18) hat eine zu ihrer Stirnseite (31) offene Aussparung (30), die seitlich von Federarmen (41, 42) begrenzt ist, an denen sich Kontaktflächen für die elektrische Verbindung befinden.

## Beschreibung

Die vorliegende Erfindung betrifft eine Verbindungsvorrichtung, mit einer zum Tragen von elektrischen Bauelementen und/oder elektrischen Leitern vorgesehenen Trägerplatte aus elektrisch nicht leitfähigem Material, die zur Herstellung einer elektrischen Verbindung mit Kontaktgegenmitteln eines anderen Bauteils dienende Kontaktmittel aufweist, und die mit einer zu einer Stirnseite der Trägerplatte hin offenen Aussparung versehen ist, wobei die die Aussparung auf gegenüberliegenden Seiten begrenzenden Seitenwände jeweils eine elektrisch leitfähige Kontaktfläche der Kontaktmittel aufweisen, die bei hergestellter elektrischer Verbindung gegen eine in die Aussparung eingreifende Kontaktgegenfläche der Kontaktgegenmittel gedrückt ist.

Eine derartige Verbindungsvorrichtung geht aus der DE 29621580 U1 hervor. Sie wird dort für die Übertragung elektrischer Energie insbesondere in Gestalt von Hochfrequenz-Signalen eingesetzt. Allerdings dürfte sich die Bauform grundsätzlich auch für einen auf dem Betätigungsfeld der Anmelderin anzutreffenden Anwendungsfall eignen, bei dem beispielsweise eine elektrische Verbindung zwischen einem die Kontaktgegenmittel aufweisenden Elektromagneten für ein Elektromagnetventil und einer den Elektromagneten steuernden bzw. regelnden Ansteuerschaltung hergestellt werden soll. Das mit den Kontaktmitteln der Trägerplatte elektrisch zu verbindende Bauteil, im Beispielsfalle der Elektromagnet, wird dabei häufig von Zulieferanten bezogen, so daß sich im Falle des Aufeinandertreffens ungünstiger Toleranzpaarungen Kontaktschwierigkeiten einstellen können. Solche Toleranzschwankungen bei den Kontaktgegenmitteln können nicht ohne weiteres durch eine entsprechende Anpassung der Kontaktmittel der Trägerplatte ausgeglichen werden, da dies einen erheblichen Herstellungsaufwand und hohe Kosten mit sich bringen würde.

Es ist daher die Aufgabe der vorliegenden Erfindung, eine Verbindungsvorrichtung zu schaffen, wobei die Kontaktmittel der Trägerplatte auch bei Toleranzschwankungen der Kontaktgegenmittel eine gute elektrische Verbindung gewährleisten.

Diese Aufgabe wird erfindungsgemäß dadurch gelöst, daß die Kontaktflächen jeweils an einem in seiner Querrichtung federelastisch bewegbaren Federarm der Trägerplatte vorgesehen sind, derart, daß die beiden Federarme durch die in die Aussparung eingreifenden Kontaktgegenmittel entgegen einer Rückstellkraft auseinandergespreizt werden und die Kontaktgegenmittel zangenartig beaufschlagen.

Auf Grund der in Querrichtung federelastischen Federarme werden Toleranzschwankungen bei den Kontaktgegenmitteln in einem relativ weiten Rahmen ausgeglichen, so daß auch bei größeren Toleranzabweichungen eine gute mechanische und elektrische Verbindung zwischen Kontaktmitteln und Kontaktgegenmitteln gewährleistet ist. Dazuhin ist die Gefahr von plastischen Verformungen bei den Kontaktgegenmitteln sehr gering. Da die Klemmkraft von der Rückstellkraft der Federarme hervorgerufen wird, sind an die Ausgestaltung der Kontaktgegenmittel keine besonderen Anforderungen hinsichtlich der Erzeugung der mechanischen Verbindung zu stellen, was dazu führt, daß die Verbindungsvorrichtung einen Einsatz mit verschieden ausgeführten Kontaktgegenmitteln gestattet.

Vorteilhafte Weiterbildungen des Gegenstands der Erfindung gehen aus den Unteransprüchen hervor.

Zweckmäßigerweise sind die Kontaktflächen der Kontaktmittel zum Herstellen zweier separater elektrischer Verbindungen mit zwei separaten Kontaktelementen der Kontaktgegenmittel vorgesehen. Beispielsweise können die Kontaktflächen der Kontaktmittel zum Herstellen einer zweipoligen elektrischen Verbindung mit den Kontaktgegenflächen der Kontaktgegenmittel dienen. Auf diese Weise können die beiden elektrischen Verbindungen, die zwischen jeweils einer Kontaktfläche und der zugeordneten Kontaktgegenfläche hergestellt sind, auf unterschiedlichen elektrischen Potentialen liegen.

Vorteilhafterweise sind die Kontaktflächen im Bereich der freien äußeren Enden der Federarme vorgesehen. In diesem Bereich ist die federelastische Bewegbarkeit der Federarme in ihrer Querrichtung am größten, wodurch ein guter elektrischer Kontakt zwischen Kontaktflächen und Kontaktgegenflächen erreichbar ist.

Es ist auch zweckmäßig, wenn die Kontaktflächen von auf die Seitenwände der Aussparung der Trägerplatte aufgebrachtem, elektrisch leitfähigem Material gebildet sind. Hierbei können eventuell auf der Trägerplatte vorgesehene Leiterbahnen auf einfache Weise mit der Kontaktfläche verbunden werden, wobei die Kontaktfläche gleichzeitig eine Art Durchkontaktierung darstellt, so daß die Möglichkeit besteht, eventuell auf beiden Tragseiten der Trägerplatte vorgesehene Leiterbahnen auf einfache Weise mit den Kontaktflächen zu verbinden.

Die beiden Kontaktflächen können des weiteren Bestandteile zweier separater Leitschichten sein, die die Innenfläche der Aussparung zumindest teilweise überdecken. Insbesondere erfolgt die elektrische Verbindung zwischen mindestens einem auf der Trägerplatte vorgesehenen Bauelement und/oder Leiter und wenigstens einer der Kontaktflächen über die betreffende Leitschicht. Auf diese Weise kann die Verbindung an einer beliebigen Stelle der Leitschicht erfolgen, so daß die Position des Bauelementes bzw. der Verlauf des Leiters auf der Trägerplatte in weitem Rahmen wählbar ist.

Ferner ist es zweckmäßig, wenn sich ausgehend von der Grundseite der Aussparung in Richtung zu der dieser gegenüberliegenden offenen Seite der Aussparung eine Zunge erstreckt, die zusammen mit den Federarmen zwei Eingriffsbereiche der Aussparung begrenzt, in die bei hergestellter elektrischer Verbindung jeweils ein mit einer der Kontaktgegenflächen versehenes Kontaktelement der Kontaktgegenmittel eingreifen kann. Die Zunge füllt bei hergestellter elektrischer Verbindung den Freiraum zwischen den beiden Kontaktelementen zumindest teilweise aus und kann auf den beiden Trägerflächen der Trägerplatte für das Anordnen von Bauelementen und/oder Leitern, zum Beispiel Leiterbahnen, einen zusätzlichen Flächenabschnitt zur Verfügung stellen.

Bei einer weiteren vorteilhaften Ausführungsform ist ein Gehäuse vorhanden, an dem die Trägerplatte insbesondere lösbar anbringbar ist. Hierbei kann das Gehäuse einen zum Befestigen des die Kontaktgegenmittel aufweisenden Bauteils dienenden Befestigungsabschnitt aufweisen, wobei die Kontaktgegenmittel bei befestigtem Bauteil durch wenigstens eine zugeordnete Gehäuseöffnung in einen Verbindungsbereich des Gehäuses hineinragen, in dem sich bei am Gehäuse angebrachter Trägerplatte deren Kontaktmittel befinden. Somit kann über das Gehäuse eine Positionierung von Trägerplatte und dem die Kontaktgegenmittel enthaltenden Bauteil erfolgen, die sowohl eine sichere mechanische als auch eine sichere elektrische Verbindung zwischen Kontaktmitteln und Kontaktgegenmitteln gewährleistet.

Hierbei ist es vorteilhaft, wenn an dem Gehäuse einem jeweiligen Federarm innerhalb der Aussparung mit Abstand gegenüberliegende Stützvorsprünge vorgesehen sind, die zur seitlichen Abstützung der bei hergestellter Verbindung von einem Federarm beaufschlagten Kontaktgegenmittel dienen.

Bei dieser Ausführung können am Gehäuse zwei Gehäuseöffnungen für jeweils ein Kontaktelement der Kontaktgegenmittel vorgesehen sein, wobei sich die Stützvorsprünge ausgehend von jeweils einem Randbereich einer der Gehäuseöffnungen in den Verbindungsbereich hinein erstrecken und bei am Gehäuse angebrachter Trägerplatte unter Abstand zum zugeordneten Federarm in die Aussparung der Trägerplatte eingreifen, so daß sie das bei hergestellter elektrischer Verbindung jeweils zwischen dem Stützvorsprung und dem zugeordneten Federarm befindliche Kontaktelement entgegen der Rückstellkraft des Federarms abstützen. Auf Grund dieser Maßnahme wird ein versehentliches Verformen der Kontaktelemente noch sicherer vermieden.

Im folgenden wird ein Ausführungsbeispiel der erfindungsgemäßen Verbindungsvorrichtung anhand der beigefügten Zeichnung näher erläutert. Es zeigen:
- Fig. 1: ein erstes Ausführungsbeispiel einer erfindungsgemäßen Verbindungsvorrichtung in teilgeschnittener Schrägbilddarstellung bei hergestellter elektrischer Verbindung zwischen den Kontaktmitteln der Trägerplatte und den Kontaktgegenmitteln des separaten Bauteils und
- Fig. 2: das Ausführungsbeispiel der Trägerplatte aus Fig. 1 im unbestückten Zustand in einer Draufsicht quer zu seiner Erstreckungsrichtung mit schematisch angedeuteten Kontaktgegenmitteln.

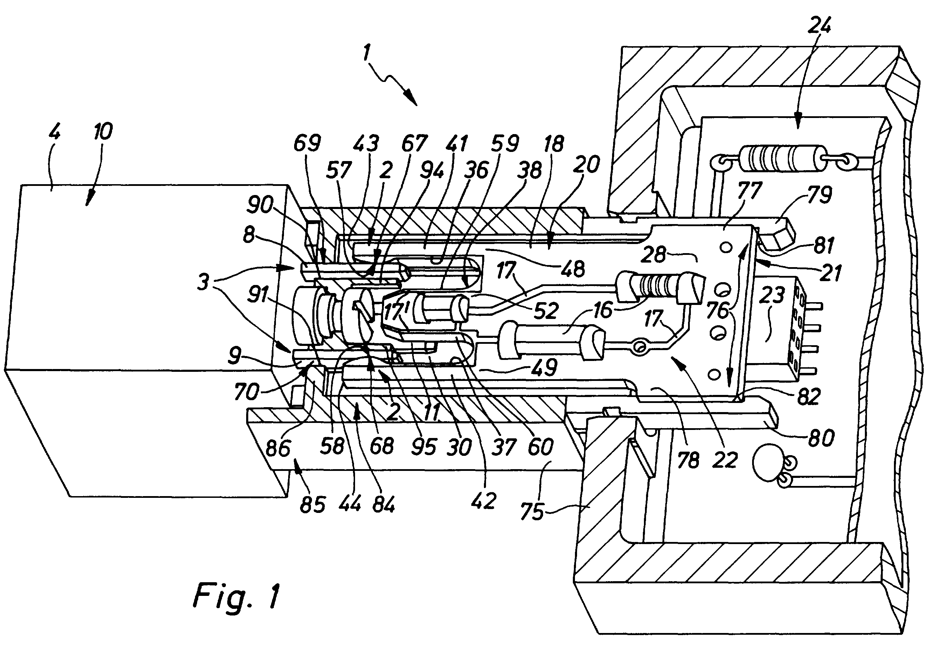

In Fig. 1 ist eine Verbindungsvorrichtung 1 gezeigt, die zum Herstellen einer elektrischen Verbindung dient. Hierfür weist die Verbindungsvorrichtung 1 elektrisch leitfähige Kontaktmittel 2 auf, die zum Herstellen der elektrischen Verbindung mit ebenfalls elektrisch leitfähigen Kontaktgegenmitteln 3 eines separaten Bauteils 4 in Kontakt bringbar sind.

Das separate Bauteil 4 ist beispielsgemäß von einem Elektromagneten eines nicht näher dargestellten Elektromagnetventils gebildet, das mit dem Elektromagneten verbindbar ist. Es versteht sich, daß alternativ zum dargestellten Ausführungsbeispiel das Bauteil 4 auch jede beliebige andere elektrische Baueinheit darstellen könnte. Bei einer solchen Baueinheit muß es sich nicht lediglich um ein einzelnes elektrisches Bauteil handeln, sondern es kann auch eine beliebige elektrische bzw. elektronische Schaltungsanordnung vorgesehen sein.

Die Kontaktgegenmittel 3 des Elektromagneten 4 sind beim Ausführungsbeispiel von zwei separaten Kontaktelementen 8, 9 gebildet. Diese sind stiftartig ausgeführt und ragen im wesentlichen parallel zueinander quer vom Gehäuse 10 des Elektromagneten 4 weg. Der Elektromagnet 4 kann des weiteren zusätzliche elektrische Anschlüsse aufweisen, wobei im vorliegenden Fall ein Masseanschluß 11 vorhanden ist.

Die Verbindungsvorrichtung enthält eine zum Tragen von elektrischen Bauelementen 16 und/oder elektrischen Leitern 17 vorgesehene Trägerplatte 18 aus elektrisch nicht leitfähigem Material. Die Trägerplatte 18 ist beispielsgemäß als Leiterplatte ausgeführt, so daß die elektrischen Leiter 17 in Form von Leiterbahnen realisiert sind, die mit Anschlußflächen 19 (pads) verbunden sein können, an die ein Bauelement 16 angelötet oder auf andere Art elektrisch verbunden werden kann. Bei der hier vorliegenden Ausführungsform der Trägerplatte 18 ist diese zum Tragen von sogenannten SMD-Bauelementen 16 (surface mounted device) vorgesehen und kann von beiden entgegengesetzten Trägerflächen 20, 21 her mit derartigen Bauelementen 16 bestückt werden.

Die an der Trägerplatte 18 angeordneten Bauelemente 16 und Leiterbahnen 17 bilden eine elektrische bzw. elektronische Schaltungsanordnung 22, die die Ansteuerschaltung des Elektromagneten 4 oder zumindest einen Teil davon darstellt. Über einen Anschlußstecker 23 der Schaltungsanordnung 22 besteht die Möglichkeit, diese mit zusätzlichen Schaltungsteilen 24 elektrisch zu verbinden oder die Schaltungsanordnung 22 z.B. mit elektrischer Energie zu versorgen.

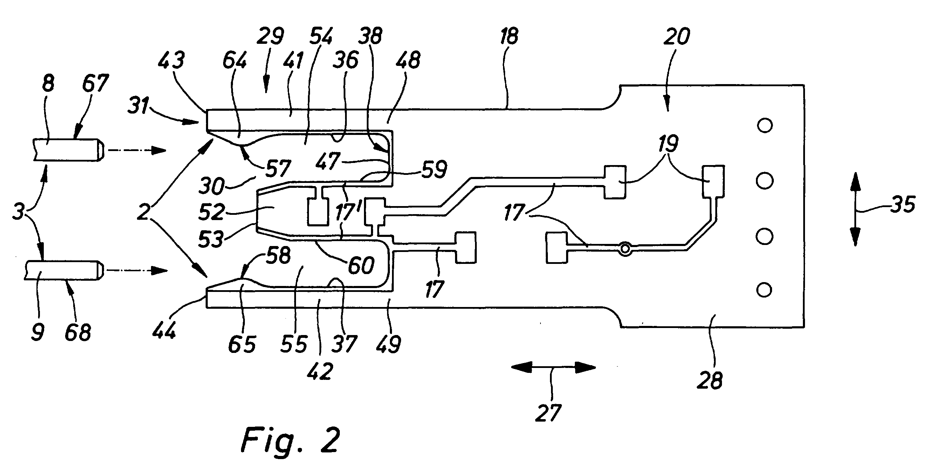

Die Trägerplatte 18 ist in Fig. 1 gebrauchsfertig bereits mit der Schaltungsanordnung 22 versehen, während Fig. 2 diese als Leiterplatte ausgebildete Trägerplatte 18 in unbestücktem Zustand zeigt.

Grundsätzlich ist die Gestalt der Trägerplatte 18 beliebig wählbar. In der bevorzugten Ausführungsform ist sie länglich ausgebildet, wobei in Längsrichtung 27 gesehen der eine, erste Endbereich 28 quer zur Längsrichtung 27 erweitert ist. Sowohl der erste Endbereich 28 als auch die übrige Partie der Trägerplatte sind im wesentlichen rechteckähnlich konturiert.

In dem dem ersten Endbereich 28 in Längsrichtung 27 entgegengesetzten zweiten Endbereich 29 der Trägerplatte 18 ist eine Aussparung 30 vorgesehen, die zu einer Stirnseite 31 der Trägerplatte 18 hin offen ist. Im vorliegenden Fall ist die Aussparung 30 zu der in Längsrichtung 27 weisenden Stirnseite 31 des zweiten Endbereichs 29 hin offen.

In Querrichtung 35 ist die Aussparung 30 von zwei sich längs erstreckenden Seitenwänden 36, 37 begrenzt, die einander mit Abstand gegenüberliegen und jeweils einen Abschnitt der Innenfläche 38 der Aussparung 30 bilden. Die Seitenwände 36, 37 verlaufen zumindest abschnittsweise und beispielsgemäß vollständig an jeweils einem in Querrichtung 35 federelastisch bewegbaren Federarm 41, 42 der Trägerplatte 18. Diese Federarme 41, 42 erstrecken sich beiderseits der Aussparung 30 in Längsrichtung 27 und werden sozusagen von dem nach dem Einbringen der Aussparung stehengebliebenen Material der Trägerplatte gebildt. Zwischen den beiden freien Enden 43, 44 der Federarme 41, 42 befindet sich die offene Seite der Aussparung 30.

Im Bereich der der offenen Seite entgegengesetzten Grundseite 47 der Aussparung 30 sind die Federarme 41, 42 mit ihrem dem jeweils äußeren freien Ende 43, 44 entgegengesetzten inneren Ende 48, 49 federelastisch verschwenkbar. Die Federelastizität der Federarme 41, 42 rührt daher, daß ihre Stärke in Querrichtung 35 entsprechend dünn bemessen ist. Hieraus ergibt sich, daß die Stellen mit größerem Abstand zum inneren Ende 48, 49 stärker in Querrichtung 35 auslenkbar sind als die Stellen, die näher am inneren Ende 48, 49 des jeweiligen Federarms 41, 42 liegen.

Insgesamt gesehen ist der die Aussparung 30 und die Federarme 41, 42 aufweisende zweite Endbereich der Trägerplatte 18 zangenartig gestaltet.

Von der Grundseite 47 der Aussparung 30 her erstreckt sich eine Zunge 52 in Längsrichtung 27 zur offenen Seite der Aussparung 30 hin. Ihre Länge ist zweckmäßigerweise geringer als die der beiden Federarme 41, 42, so daß ihr freies Ende 53 innerhalb der Aussparung 30 liegt. Die Zunge 52 begrenzt mit den Federarmen 41, 42 zwei Eingriffsbereiche 54, 55 für die Kontaktelemente 8, 9 der Kontaktgegenmittel 3, die bei hergestellter elektrischer Verbindung zwischen den Kontaktmitteln 2 und den Kontaktgegenmitteln 3 in die Eingriffsbereiche 54, 55 eingreifen können, worauf später noch näher eingegangen wird.

Die Kontaktmittel 2 sind an der Trägerplatte 18 vorgesehen. Sie verfügen über zwei elektrisch leitfähige Kontaktflächen 51, 58, die an den Seitenwänden 36, 37 der Aussparung 30 vorgesehen sind. Beim bevorzugten Ausführungsbeispiel befinden sich die Kontaktflächen 57, 58 im Bereich der offenen Seite der Aussparung 30 an den freien äußeren Enden 43, 44 der Federarme 41, 42 und sind einander zugewandt. Sie sind beim bevorzugten Ausführungsbeispiel der Trägerplatte 18 von auf die Seitenwände 36, 37 aufgebrachtem, elektrisch leitfähigem Material gebildet, zum Beispiel Kupfer, das zusätzlich auch verzinnt werden kann.

Die Kontaktflächen 57, 58 stellen beispielsgemäß Bestandteile jeweils einer separaten Leitschicht 59, 60 dar, die die Innenfläche 38 der Aussparung 30 fast vollständig belegen, wobei lediglich die Stirnfläche des freien Endes 53 der Zunge 52 frei ist von einer Leitschicht. An der Stirnfläche ist daher sozusagen die Trennstelle der beiden Leitschichten 59, 60 vorgesehen, die sich jedoch alternativ auch an einer anderen Stelle der Innenfläche 38 der Aussparung 30 befinden könnte.

Die beiden Leitschichten 59, 60 sind beim Ausführungsbeispiel entlang ihres Verlaufes auf beiden Trägerflächen 20, 21 der Trägerplatte 18 mit einer die Aussparung 30 im Bereich der Leitschichten 59, 60 umrandenden Leiterbahn 17' verbunden. An diese randseitige Leiterbahn 17' können an beliebigen Stellen die elektrisch mit einer der Kontaktflächen 57, 58 zu verbindenden Leiterbahnen 17 angeschlossen sein. Hierdurch ist es nicht notwendig, Leiterbahnen direkt bis zur betreffenden Kontaktfläche 57, 58 zu verlegen, sondern die elektrische Verbindung kann über die betreffende Leitschicht 59, 60 bzw. die damit verbundene randseitige Leiterbahn 17' erfolgen.

Um einen guten Kontakt zwischen den Kontaktmitteln 2 und den Kontaktgegenmitteln 3 zu gewährleisten, sind die Kontaktflächen 57, 58 der Kontaktmittel 2 jeweils an einem seitlich in Querrichtung 35 in die Aussparung 30 vorstehenden Kontaktvorsprung 64, 65 des betreffenden Federarms 41, 42 vorgesehen. Die Kontaktvorsprünge 64, 65 haben eine abgerundete, ausgewölbte Gestalt, wobei sich die Kontaktflächen 57, 58 im Bereich der am weitesten in die Aussparung 30 hineinragenden Stelle des jeweiligen Kontaktvorsprunges 64, 65 befinden.

Die Kontaktgegenmittel 3 verfügen über Kontaktgegenflächen 67, 68, die bei hergestellter elektrischer Verbindung mit den Kontaktflächen 57, 58 der Kontaktmittel 2 zur Anlage gelangen. Beim Ausführungsbeispiel sind die Kontaktgegenflächen 67, 68 an der vom jeweils anderen Kontaktelement 8 bzw. 9 wegweisenden Außenseite 69, 70 eines Kontaktelelementes 8, 9 vorgesehen. Bei hergestellter elektrischer Verbindung, die beispielsgemäß durch Zusammenstecken der Kontaktmittel 2 und der Kontaktgegenmittel 3 erreicht wird, sind die Kontaktgegenflächen 67, 68 in Querrichtung 35 in entgegengesetzte Richtungen weisend ausgerichtet. Die Kontaktelemente 8, 9 greifen mit ihrer jeweiligen Kontaktgegenfläche 67, 68 in die Aussparung 30 der Trägerplatte 18 ein. Hierbei werden die Federarme 41, 42 auf Grund ihrer Federelastizität in Querrichtung 35 etwas auseinandergespreizt, wodurch eine Rückstellkraft der Federarme 41, 42 hervorgerufen wird, die die Kontaktflächen 57, 58 zangenartig von außen gegen die jeweils zugeordnete Kontaktgegenfläche 67, 68 der Kontaktelemente 8, 9 drückt. Hierdurch wird eine gute elektrische Verbindung zwischen den Kontaktflächen 57, 58 und der betreffenden Kontaktgegenfläche 67, 68 geschaffen.

Die Kontaktelemente 8, 9 der Kontaktgegenmittel 3 werden vom zugeordneten Federarm 41, 42 lediglich von einer Seite her beaufschlagt.

Die Kontaktflächen 57, 58 sind elektrisch separat ausgeführt, das heißt, sie können beim Gebrauch der Verbindungsvorrichtung 1 elektrisch auf unterschiedlichen Potentialen liegen. Dies führt dazu, daß mittels der beiden Kontaktflächen 57, 58 zwei separate elektrische Verbindungen herstellbar sind, so daß die beiden Paare von Kontaktfläche und zugeordneter Kontaktgegenfläche 57, 67 bzw. 58, 68 jeweils einen Pol der elektrischen Verbindung zwischen Kontaktmitteln 2 und Kontaktgegenmitteln 3 darstellen. Jede Kontaktfläche 57, 58 der Kontaktmittel 2 dient somit zum Herstellen eines Pols der elektrischen Verbindung.

Wie dies aus Fig. 1 hervorgeht, verfügt die Verbindungsvorrichtung 1 zweckmäßigerweise über ein Gehäuse 75, an dem die Trägerplatte 18 lösbar angebracht werden kann, wobei hierfür insbesondere eine Rastverbindungseinrichtung 76 dient.

Beim Ausführungsbeispiel verfügt die Trägerplatte 18 über zwei Rastvorsprünge 77, 78, die von einer jeweiligen, den ersten Endbereich 28 der Trägerplatte 18 in deren Querrichtung 35 erweiternden Partie gebildet sind. Diesen Rastvorsprüngen 77, 78 sind an federelastisch beweglichen Rastarmen 79, 80 des Gehäuses 75 befindliche Rastausnehmungen 81, 82 zugeordnet, in die die Rastvorsprünge 77, 78 bei hergestellter Rastverbindung eingreifen, wobei die Rastarme 79, 80 beim Herstellen der Rastverbindung federelastisch ausweichen. Es versteht sich, daß umgekehrt zum dargestellten Ausführungsbeispiel die Rastvorsprünge 77, 78 auch am Gehäuse 75 und die Rastausnehmungen 81, 82 entsprechend an der Trägerplatte 18 vorgesehen sein könnten. Auch eine sonstige beliebige Abwandlung der Rastverbindungseinrichtung 76 ist möglich. Grundsätzlich könnte anstelle der Rastverbindungseinrichtung 76 auch jede andere Einrichtung zur lösbaren Verbindung der Trägerplatte 18 am Gehäuse 75 eingesetzt werden.

Bei am Gehäuse 75 angebrachter Trägerplatte 18 befinden sich die Kontaktmittel 2 in einem Verbindungsbereich 84 des Gehäuses 75. Angrenzend an den Verbindungsbereich 84 verfügt das Gehäuse 75 über einen zum Befestigen des vom Elektromagneten gebildeten Bauteils 4 dienenden Befestigungsabschnitt 85. Beispielsgemäß sind der Befestigungsabschnitt 85 und der Verbindungsbereich 84 durch eine quer verlaufende Trennwand 86 des Gehäuses 75 voneinander abgetrennt, die jedoch in Abwandlung zum dargestellten Ausführungsbeispiel auch entfallen könnte.

Der Elektromagnet 4 bzw. dessen Gehäuse 10 ist am Befestigungsabschnitt 85 derart anbringbar, daß die Kontaktgegenmittel 3 sich in einer die elektrische Verbindung mit den Kontaktmitteln 2 ermöglichenden Lage befinden. Hierfür umgreifen zwei Wandpartien 87, 88 das Gehäuse 10 des Elektromagneten 4 von wenigstens zwei entgegengesetzten Seiten her, so daß eine Zentrierung bzw. Positionierung des Elektromagneten 4 bezüglich des Gehäuses 75 der Verbindungsvorrichtung 1 vorliegt. Zum Befestigen des Elektromagneten 4 am Gehäuse 75 kann beispielsweise eine Schraubverbindung verwendet werden, wobei gemäß Fig. 1 zu diesem Zweck eine Durchbrechung in der Trennwand 86 vorhanden ist.

In der Trennwand 86 sind des weiteren zwei Gehäuseöffnungen 90, 91 vorgesehen, die den Kontaktelementen 8, 9 der Kontaktgegenmittel 3 zugeordnet sind und in Gebrauchslage ein Durchgreifen der Kontaktelemente 8, 9 vom Befestigungsabschnitt 85 in den Verbindungsbereich 84 ermöglichen.

Zum Abstützen der Kontaktelemente 8, 9 der Kontaktgegenmittel 3 in Querrichtung 35 weist das Gehäuse 75 Stütz-vorsprünge 94, 95 auf, die jeweils einem Federarm 41, 42 zugeordnet sind. Sie liegen diesem Federarm 41 bzw. 42 mit Abstand gegenüber und greifen bei am Gehäuse 75 angebrachter Trägerplatte 18 in dessen Aussparung 30 ein.

Beim Ausführungsbeispiel sind die Stützvorsprünge 94, 95 an der Trennwand 86 in Verlängerung des Randbereiches einer jeweiligen Gehäuseöffnung 90, 91 an den einander zugewandten Seiten vorgesehen und ragen ausgehend von der Trennwand 86 quer in den Verbindungsbereich 84 hinein. Die Stützvorsprünge 94, 95 stehen beispielsgemäß mit ihrem äußeren freien Endabschnitt jeweils in einen Eingriffsbereich 54, 55 der Aussparung 30 vor und verlaufen hierbei im wesentlichen parallel zur Erstreckungsrichtung der Federarme 41, 42. Dabei sind sie zum jeweils zugeordneten Federarm 41, 42 beabstandet. In den dadurch vorhandenen Zwischenraum greift das betreffende Kontaktelement 8, 9 der Kontaktgegenmittel 3 bei zusammengesteckter Verbindung ein, wobei es mit seiner Kontaktgegenfläche 67, 68 auf der einen Seite an der zugeordneten Kontaktfläche 57, 58 des Federarms 41, 42 anliegt und von der entgegengesetzten Seite her vom benachbarten Stützvorsprung 94, 95 abgestützt wird.

Sind sowohl die Trägerplatte 18 als auch der Elektromagnet 4 am Gehäuse 75 der Verbindungsvorrichtung 1 angeordnet, so stützen die Stützvorsprünge 94, 95 die beiden Kontaktelemente 8, 9 entgegen der durch das Auseinanderspreizen der Federarme 41, 42 erzeugten Rückstellkraft ab und verhindern eine Deformation der Kontaktelemente 8, 9.

## Patentansprüche

1. Verbindungsvorrichtung, mit einer zum Tragen von elektrischen Bauelementen (16) und/oder elektrischen Leitern (17) vorgesehenen Trägerplatte (18) aus elektrisch nicht leitfähigem Material, die zur Herstellung einer elektrischen Verbindung mit Kontaktgegenmitteln (3) eines anderen Bauteils (4) dienende Kontaktmittel (2) aufweist, und die mit einer zu einer Stirnseite (31) der Trägerplatte (18) hin offenen Aussparung (30) versehen ist, wobei die die Aussparung (30) auf gegenüberliegenden Seiten begrenzenden Seitenwände (36, 37) jeweils eine elektrisch leitfähige Kontaktfläche (57, 58) der Kontaktmittel (2) aufweisen, die bei hergestellter elektrischer Verbindung gegen eine in die Aussparung eingreifende Kontaktgegenfläche (67, 58) der Kontaktgegenmittel (3) gedrückt ist, dadurch gekennzeichnet, daß die Kontaktflächen (57, 58) jeweils an einem in seiner Querrichtung (35) federelastisch bewegbaren Federarm (41, 42) der Trägerplatte (18) vorgesehen sind, derart, daß die beiden Federarme (41, 41) durch die in die Aussparung (30) eingreifenden Kontaktgegenmittel (3) entgegen einer Rückstellkraft auseinandergespreizt werden und die Kontaktgegenmittel (3) zangenartig beaufschlagen.

2. Verbindungsvorrichtung nach Anspruch 1, dadurch gekennzeichnet, daß die Kontaktflächen (57, 58) der Kontaktmittel zum Herstellen zweier separater elektrischer Verbindungen mit zwei separaten Kontaktelementen (8, 9) der Kontaktgegenmittel (3) vorgesehen sind.

3. Verbindungsvorrichtung nach Anspruch 1 oder 2, dadurch gekennzeichnet, daß die Kontaktflächen (57, 58) der Kontaktmittel (2) zum Herstellen einer zweipoligen elektrischen Verbindung mit den Kontaktgegenflächen (67, 68) der Kontaktgegenmittel (3) vorgesehen sind.

4. Verbindungsvorrichtung nach einem der Ansprüche 1 bis 3, dadurch gekennzeichnet, daß die Kontaktflächen (57, 58) im Bereich der freien äußeren Enden (43, 44) der Federarme (41, 42) vorgesehen sind.

5. Verbindungsvorrichtung nach einem der Ansprüche 1 bis 4, dadurch gekennzeichnet, daß die Kontaktflächen (57, 58) jeweils an einem seitlich in die Aussparung (30) hineinragenden Kontaktvorsprung (64, 65) des betreffenden Federarms (41, 42) vorgesehen sind.

6. Verbindungsvorrichtung nach einem der Ansprüche 1 bis 5, dadurch gekennzeichnet, daß die Kontaktflächen (57, 58) von auf die Seitenwände (36, 37) der Aussparung (30) der Trägerplatte (18) aufgebrachtem, elektrisch leitfähigem Material gebildet sind.

7. Verbindungsvorrichtung nach einem der Ansprüche 1 bis 6, dadurch gekennzeichnet, daß die beiden Kontaktflächen (57, 58) Bestandteile zweier separater Leitschichten (59, 60) sind, die die Innenfläche (38) der Aussparung (30) zumindest teilweise überdecken.

8. Verbindungsvorrichtung nach Anspruch 7, dadurch gekennzeichnet, daß die elektrische Verbindung zwischen mindestens einem auf der Trägerplatte (18) vorgesehenen Bauelement (16) und/oder Leiter (17) und wenigstens einer der Kontaktflächen (57, 58) über die betreffende Leitschicht (59, 60) erfolgt.

9. Verbindungsvorrichtung nach einem der Ansprüche 1 bis 8, dadurch gekennzeichnet, daß eine sich ausgehend von der Grundseite (47) der Aussparung (30) in Richtung der dieser gegenüberliegenden offenen Seite der Aussparung (30) erstreckende Zunge (52) vorgesehen ist, die zusammen mit den Federarmen (41, 42) zwei Eingriffsbereiche (54, 55) der Aussparung (30) begrenzt, in die bei hergestellter elektrischer Verbindung jeweils ein mit einer der Kontaktgegenflächen (67, 68) versehenes Kontaktelement (8, 9) der Kontaktgegenmittel (3) eingreifen kann.

10. Verbindungsvorrichtung nach Anspruch 9 in Verbindung mit Anspruch 7 oder 8, dadurch gekennzeichnet, daß die Innenfläche (38) der Aussparung (30) mit Ausnahme der zur offenen Seite weisenden Stirnfläche der Zunge (52) mit einer Leitschicht (59, 50) belegt ist.

11. Verbindungsvorrichtung nach einem der Ansprüche 1 bis 10, dadurch gekennzeichnet, daß die Trägerplatte (18) als Leiterplatte ausgebildet ist.

12. Verbindungsvorrichtung nach einem der Ansprüche 1 bis 11, dadurch gekennzeichnet, daß ein Gehäuse (75) vorhanden ist, an dem die Trägerplatte (18) insbesondere lösbar angeordnet ist.

13. Verbindungsvorrichtung nach Anspruch 12, dadurch gekennzeichnet, daß zum lösbaren Verbinden von Trägerplatte (18) und Gehäuse (75) eine Rastverbindungseinrichtung (76) vorgesehen ist.

14. Verbindungsvorrichtung nach Anspruch 13, dadurch gekennzeichnet, daß die Rastverbindungseinrichtung (76) wenigstens einen an der Trägerplatte (18) vorgesehenen Rastvorsprung (77) enthält, der von einem die Trägerplatte (18) quer zur Erstreckungsrichtung der Federarme (41, 42) erweiternden Abschnitt gebildet ist, der sich im den Federarmen (41, 42) entgegengesetzten Endbereich (28) der Trägerplatte (18) befindet.

15. Verbindungsvorrichtung nach einem der Ansprüche 12 bis 14, dadurch gekennzeichnet, daß das Gehäuse (75) einen zum Befestigen des die Kontaktgegenmittel (3) aufweisenden Bauteils (4) dienenden Befestigungsabschnitt (85) aufweist, wobei die Kontaktgegenmittel (3) bei befestigtem Bauteil (4) durch wenigstens eine zugeordnete Gehäuseöffnung (90, 91) in einen Verbindungsbereich (84) des Gehäuses (75) hineinragen, in dem sich bei am Gehäuse (75) angebrachter Trägerplatte (18) deren Kontaktmittel (2) befinden.

16. Verbindungsvorrichtung nach einem der Ansprüche 12 bis 15, dadurch gekennzeichnet, daß an dem Gehäuse (75) einem jeweiligen Federarm (41, 42) innerhalb der Aussparung (30) insbesondere mit Abstand gegenüberliegende Stützvorsprünge (94, 95) vorgesehen sind, die zur seitlichen Abstützung der bei hergestellter Verbindung von einem Federarm (41, 42) beaufschlagten Kontaktgegenmittel (3) dienen.

17. Verbindungsvorrichtung nach Anspruch 16, dadurch gekennzeichnet, daß am Gehäuse (75) zwei Gehäuseöffnungen (90, 91) für jeweils ein Kontaktelement (8, 9) der Kontaktgegenmittel (3) vorgesehen sind, wobei sich die Stützvorsprünge (94, 95) ausgehend von jeweils einem Randbereich einer der Gehäuseöffnungen (90, 91) in den Verbindungsbereich (84) hinein erstrecken und bei am Gehäuse (75) angebrachter Trägerplatte (18) insbesondere unter Abstand zum zugeordneten Federarm (41, 42) in die Aussparung (30) der Trägerplatte (18) eingreifen, so daß sie das bei hergestellter elektrischer Verbindung jeweils zwischen dem Stützvorsprung (94, 95) und dem zugeordneten Federarm (41, 42) befindliche Kontaktelement (8, 9) abstützen.
